# EUROPEAN PATENT APPLICATION

(11) **EP 4 318 581 A1**
(43) Date of publication of application: **07.02.2024**
(21) Application number: 22779721.4
(22) Date of filing: 25.02.2022
(51) Int. Cl.: H01L 23/52, H01L 25/07, H01L 25/18, H01L 21/822, H01L 27/04, H02M 7/48

(54) **SEMICONDUCTOR DEVICE AND POWER CONVERTER**

(30) Priority: 30.03.2021 JP 2021058373
(71) Applicant: Nabtesco Corporation, Tokyo 102-0093 (JP)
(72) Inventor: NAKAMURA, Kazuhito, Tokyo 102-0093 (JP); INADA, Taro, Tokyo 102-0093 (JP)
(74) Representative: Grünecker Patent- und Rechtsanwälte PartG mbB
(86) International application number: PCT/JP2022/008042
(87) International publication number: WO 2022/209496

(57) **Abstract**

A semiconductor device includes: a first chip on which a transistor 1341 is formed; a second chip different from the first chip on which a transistor 1342 is formed; a package 50 comprising a mounting substrate 51 on which the first chip and the second chip are mounted; and a magnetic member 40 magnetically coupling the first chip and the second chip inside the package 50, and configuring a magnetic path that directs the magnetic flux generated by the current in one chip to another chip and induces the current in another chip in the same direction as that in the one chip.

## Description

### BACKGROUND OF THE INVENTION

### 1. Field of the Invention

The present invention relates to semiconductor device.

### 2. Description of the Related Art

In contrast to integrated circuits in which a vast number of transistors are integrated on a single chip, a semiconductor device configured by a plurality of chips are known, in which each of the semiconductor elements including a transistor is formed on a different chip and these chips are mounted inside a single package. For example, in the field of so-called power semiconductor responsible for controlling electric power, each of the semiconductor elements such as a transistor, a thyristor, or a diode is formed on a different chip so that each of the chips can handle a large amount of electric power.

Patent Literature 1: JP Patent No. 2619851

### SUMMARY OF THE INVENTION

In case each of the semiconductor elements is formed on a different chip, the current in each of the chips may deviate from the intended value due to variation in the manufacturing process of each of the chips and the like.

The present invention was made in consideration of this situation, and its purpose is to provide a semiconductor device that can effectively reduce the variation of the current in a plurality of chips.

In order to solve the above issue, a semiconductor device in a certain aspect of the present invention includes: a first chip on which a semiconductor element is formed; a second chip different from the first chip on which a semiconductor element is formed; a package comprising a mounting substrate on which the first chip and the second chip are mounted; and a magnetic member magnetically coupling the first chip and the second chip inside the package, and configuring a magnetic path that directs the magnetic flux generated by the current in one chip to another chip and induces the current in another chip in the same direction as that in the one chip.

According to the present aspect, the magnetic member magnetically coupling the first chip and the second chip, can reduce the variation of the current in both of the chips, since an increase or a decrease of the current in one chip would induce an increase or a decrease of the current in another chip.

Another aspect of the present invention is a power conversion apparatus. This power conversion apparatus includes: a DC power terminal including a high electric potential terminal at high electric potential and a low electric potential terminal at low electric potential, between which DC power is input or output; an AC power terminal in which AC power is input or output; a high electric potential transistor that connects the high electric potential terminal side and the AC power terminal side; a low electric potential transistor that connects the low electric potential terminal side and the AC power terminal side; and a driver that inputs control signals to the high electric potential transistor and the low electric potential transistor, and performs conversion between the DC power and the AC power by complementarily switching their respective conduction states. At least one of the high electric potential transistor and the low electric potential transistor includes a first transistor and a second transistor to which the same control signals are input by the driver, the first transistor is formed on a first chip, the second transistor is formed on a second chip different from the first chip, a package comprising a mounting substrate on which the first chip and the second chip are mounted is provided, and a magnetic member magnetically coupling the first chip and the second chip inside the package, and configuring a magnetic path that directs the magnetic flux generated by the current in one chip to another chip and induces the current in another chip in the same direction as that in the one chip is provided.

In addition, any combination of the above components, and any conversion of the expression of the present invention among methods, devices, systems, storage media, computer programs and the like are also effective as aspects of the present invention.

According to the present invention, the variation of the current in a plurality of chips can be effectively reduced.

### BRIEF DESCRIPTION OF THE DRAWINGS

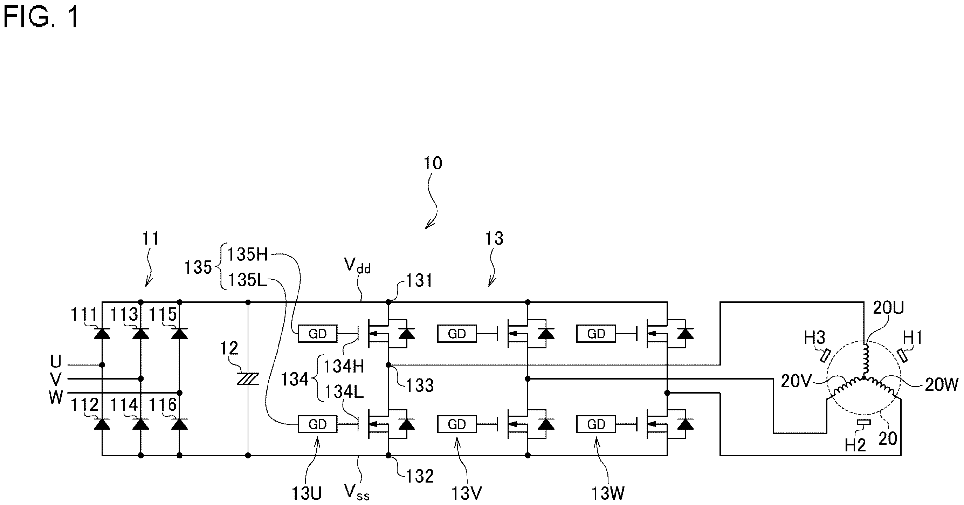

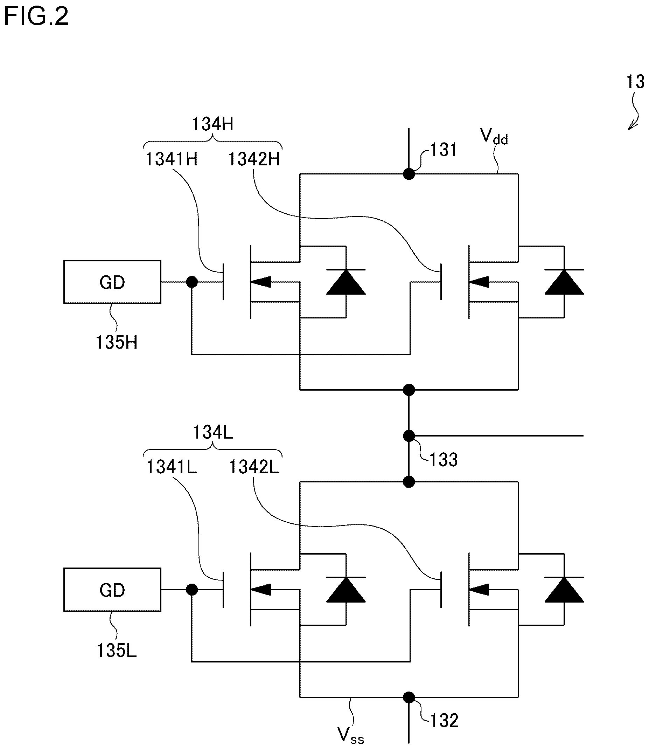

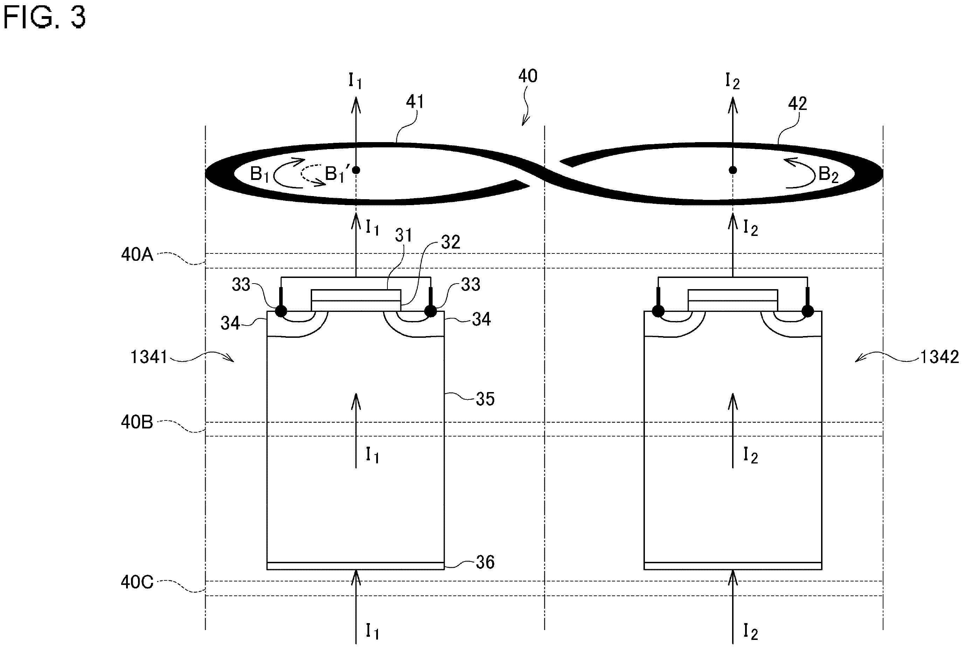

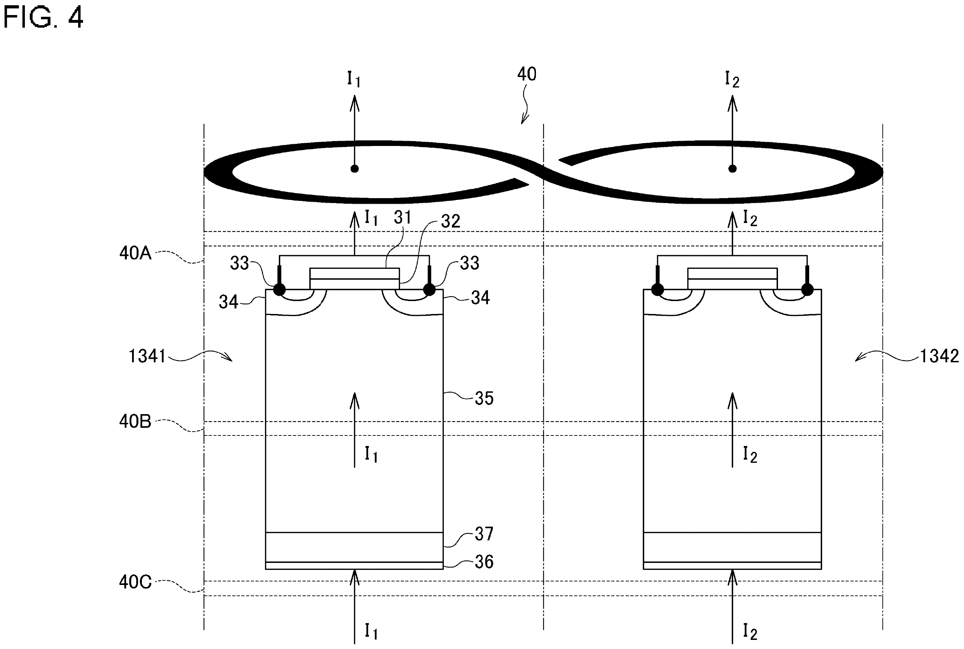

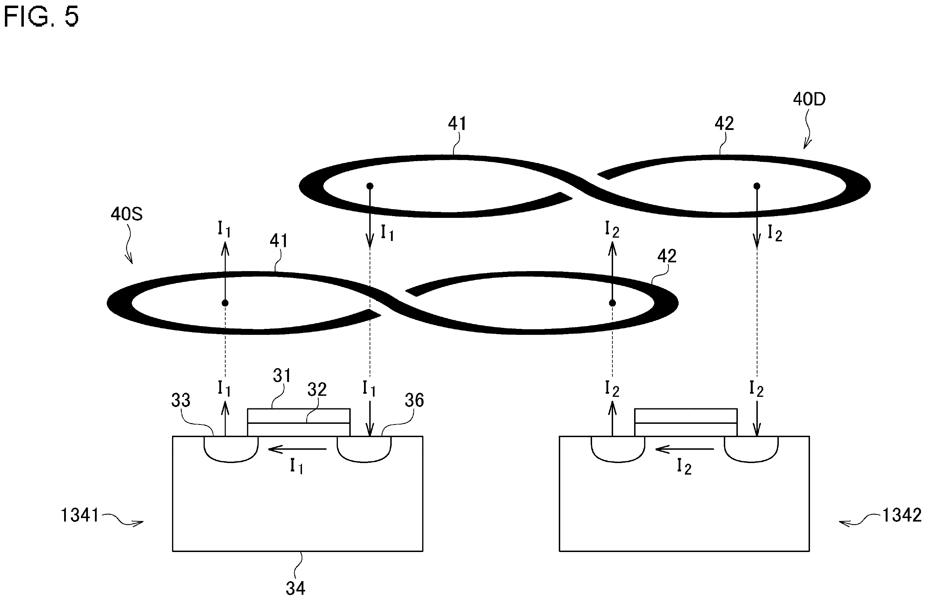

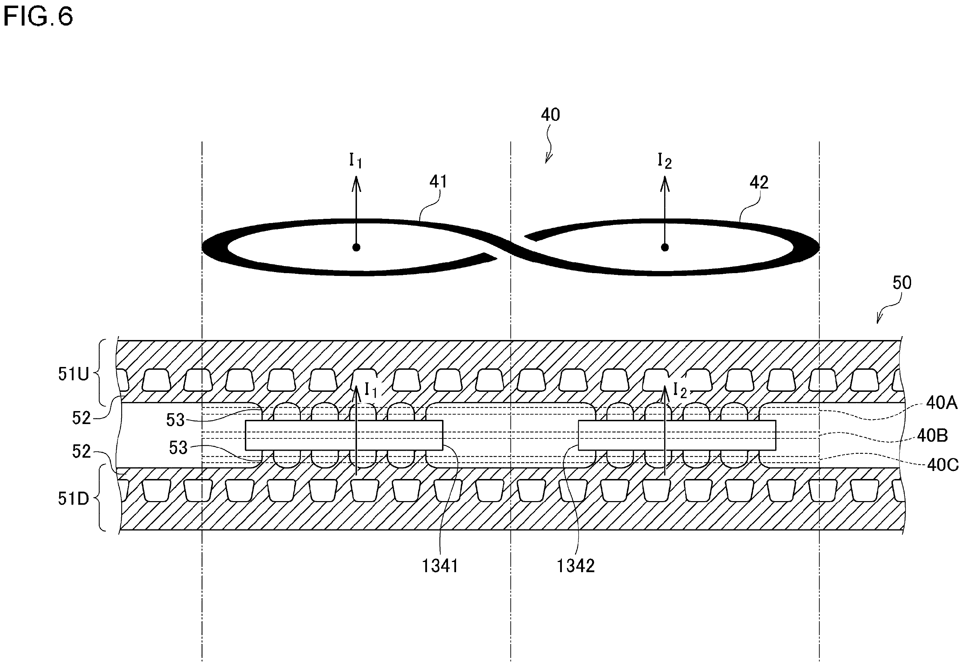

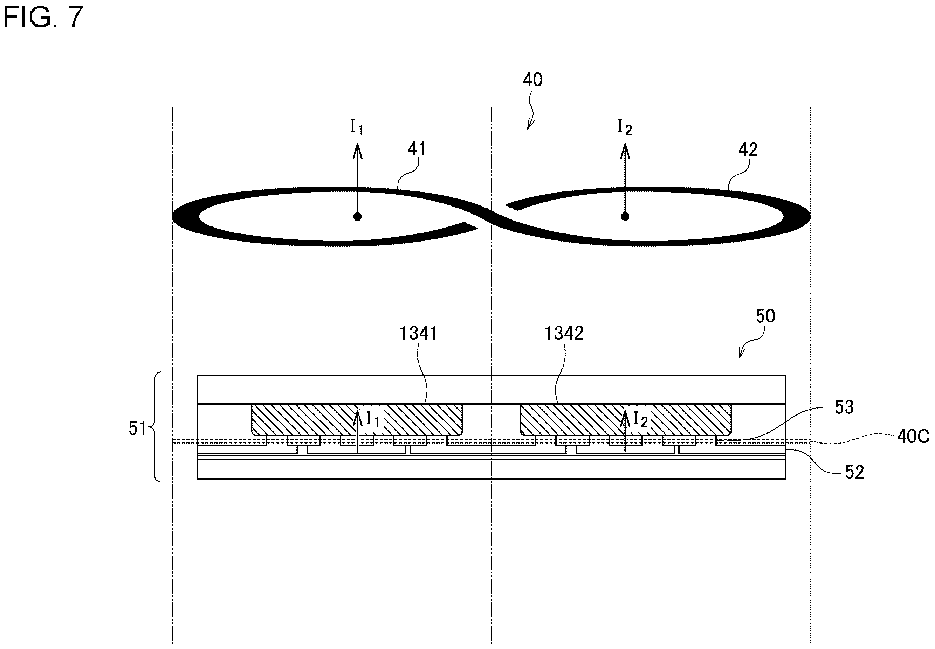

Figure 1 schematically shows a configuration of an inverter apparatus. Figure 2 shows an example of configuring a high electric potential transistor and a low electric potential transistor that constitute an inverter, by two transistors respectively. Figure 3 schematically shows a configuration that maintains the balance of the current between transistors formed on different chips. Figure 4 shows an example of applying the technological concept according to the present invention to an insulated gate bipolar transistor. Figure 5 shows an example of applying the technological concept according to the present invention to a field effect transistor with a horizontal structure. Figure 6 shows an example of mounting a plurality of transistors. Figure 7 shows another example of mounting a plurality of transistors.

### DETAILED DESCRIPTION OF THE INVENTION

Figure 1 schematically shows the configuration of an inverter apparatus 10 to which an embodiment of the present invention can be applied. The inverter apparatus 10 is equipped with a converter 11 that rectifies 3-phase AC power supplied from a power source and converts it into DC power (pulsating current), a capacitor 12 that smoothes the DC power converted by the converter 11 to adjust the waveform, and an inverter 13 that converts the DC power smoothed by the capacitor 12 into AC power.

The converter 11 is equipped with diodes 111 to 116 that rectify the 3-phase (U, V, W) AC power supplied from the power source into a certain direction (from the bottom to the top in the figure). The diode 111 flows the current when the U-phase AC voltage is positive, the diode 112 flows the current when the U-phase AC voltage is negative, the diode 113 flows the current when the V-phase AC voltage is positive, the diode 114 flows the current when the V-phase AC voltage is negative, the diode 115 flows the current when the W-phase AC voltage is positive, and the diode 116 flows the current when the W-phase AC voltage is negative. With these diodes 111-116 connected in a bridge configuration, a pulsating current in a constant direction with varying magnitude appears between the output terminals of the converter 11. The capacitor 12 supplies the DC power to the inverter 13 after smoothing the pulsating current obtained by the converter 11.

The DC voltage input between the high electric potential input terminal 131 and the low electric potential input terminal 132 of the inverter 13 through the converter 11 and the capacitor 12 is hereinafter referred to as V_{DC}. If the electric potential of the high electric potential input line to which the high electric potential input terminal 131 is connected is V_{dd} and the electric potential of the low electric potential input line to which the low electric potential input terminal 132 is connected is Vₛₛ, then V_{DC} = V_{dd} - Vₛₛ. Hereafter, unless otherwise noted, V_{DC} is assumed to be constant.

The inverter 13 is a power conversion apparatus that generates 3-phase AC power based on the DC voltage V_{DC} input between the high electric potential input terminal 131 and the low electric potential input terminal 132. Specifically, the U-phase inverter 13U that generates the U-phase AC power based on the DC voltage V_{DC}, the V-phase inverter 13V that generates the V-phase AC power based on the DC voltage V_{DC}, and the W-phase inverter 13W that generates the W-phase AC power based on the DC voltage V_{DC}, are provided in parallel. Since the configurations of the inverters 13U, 13V, and 13W of the respective phases are common, they are collectively referred to as the inverter 13 and described together as appropriate below.

The inverter 13 is equipped with a high electric potential input terminal 131 to which the high DC power source electric potential V_{dd} is input, a low electric potential input terminal 132 to which the low DC power source electric potential Vₛₛ is input, and an output terminal 133 that is provided between the high electric potential input terminal 131 and the low electric potential input terminal 132 to output the AC voltage varying between V_{dd} and Vₛₛ. A high electric potential transistor 134H is connected between the high electric potential input terminal 131 and the output terminal 133, and a low electric potential transistor 134L is connected between the low electric potential input terminal 132 and the output terminal 133. The conduction state of the high electric potential transistor 134H is switched in accordance with the control signal from the high electric potential driver 135H connected to its control electrode. The conduction state of the low electric potential transistor 134L is switched in accordance with the control signal from the low electric potential driver 135L connected to its control electrode.

Specifically, the driver pair 135 configured by the high electric potential driver 135H and the low electric potential driver 135L converts the DC power into the AC power by performing the switching control of complementarily switching the conduction states of the transistor pair 134 configured by the high electric potential transistor 134H and the low electric potential transistor 134L. Here, "complementarily switching" means controlling the on/off state of each of the transistors 134H and 134L to be opposite to each other. In other words, when the transistor 134H is on, the transistor 134L is controlled to be off; when the transistor 134H is off, the transistor 134L is controlled to be on. As such, when the high electric potential transistor 134H is on, the high electric potential V_{dd} appears at the output terminal 133, and when the low electric potential transistor 134L is on, the low electric potential Vₛₛ appears at the output terminal 133. By repeating such a switching control, the high electric potential V_{dd} and the low electric potential Vₛₛ appear alternately at the output terminal 133, generating the AC power.

It should be noted that, although Figure 1 shows an example in which the inverter 13U, 13V, and 13W of each of the phases is equipped with one transistor pair 134 and one driver pair 135 respectively, a plurality of transistor pairs and a plurality of driver pairs may be provided for each of the phases. For example, for the configuration shown in Figure 1, a second high electric potential transistor is provided between the high electric potential transistor 134H and the high electric potential input terminal 131, and a second low electric potential transistor is provided between the low electric potential transistor 134L and the low electric potential input terminal 132, so that a second transistor pair is provided outside the first transistor pair 134. The second driver pair complementarily switches the second transistor pair, whose timing is before the switching control by the first driver pair. This not only enables precise control of the AC voltage appearing at the output terminal 133, but also can increase the withstand voltage of the entire inverter 13 with the withstand voltages of a plurality of transistor pairs connected in series between the power source lines being added up.

The 3-phase AC power generated by the inverter 13 is used, for example, to drive a motor 20. The motor 20 is a 3-phase brushless motor having 3-phase coils 20U, 20V, and 20W for U, V, and W phases. The U-phase current from the U-phase inverter 13U flows through the U-phase coil 20U, the V-phase current from the V-phase inverter 13V flows through the V-phase coil 20V, and the W-phase current from the W-phase inverter 13W flows through the W-phase coil 20W. The inverters 13U, 13V, and 13W of the respective phases generate a rotating magnetic field by applying the AC power with different phases to the coils 20U, 20V, and 20W of the respective phases, based on the rotating position of the rotor detected by the Hall elements H1, H2, and H3 of the motor 20. This rotating magnetic field rotates the rotor, from which the desired rotational power is gained. It should be noted that the motor 20 may be any other type of motor driven by AC voltage. Besides, the number of phases of the motor 20 is not limited to 3, but may be any natural number of 2 or more.

A power semiconductor device, as typified by the inverter apparatus 10 described above, has been attracting attention in recent years as the key device for the growing electric vehicle and/or renewable energy, and requirements for such a product has been heightened. For example, with an increasing demand for a power semiconductor device that can handle higher electric power, the development of a high withstand voltage device, which uses so-called wide band gap semiconductor such as SiC and GaN, which has a larger band gap than that of Si, the conventional mainstream material, has been actively promoted. Besides, by providing a plurality of semiconductor elements in parallel that operate in substantially the same or similar ways, it is possible to increase the electric power that can be handled by the entire device.

Figure 2 shows an example in which the high electric potential transistor 134H and the low electric potential transistor 134L, which configure the inverter 13, are configured by two transistors respectively. Specifically, the high electric potential transistor 134H includes two high electric potential transistors 1341H and 1342H provided in parallel, and the low electric potential transistor 134L includes two low electric potential transistors 1341L and 1342L provided in parallel. Since the same control signals are input to the control electrodes of the high electric potential transistors 1341H and 1342H from the common high electric potential driver 135H, they operate unitedly as if they were a single high electric potential transistor 134H. However, at the output terminal 133, the currents from each of the high electric potential transistors 1341H and 1342H are added, resulting in an increase of the output current of the inverter 13 compared to the configuration in Figure 1. Similarly, since the same control signals are input to the control electrodes of the low electric potential transistors 1341L and 1342L from the common low electric potential driver 135L, they operate unitedly as if they were a single low electric potential transistor 134L. However, at the output terminal 133, the currents from each of the low electric potential transistors 1341L and 1342L are added, resulting in an increase of the output current of the inverter 13 compared to the configuration in Figure 1.

In the above configuration, the transistors provided in parallel are preferably formed on different chips so that each can handle as large electric power as possible. In other words, the high electric potential transistors 1341H and 1342H provided in parallel are formed on different chips from each other, and the low electric potential transistors 1341L and 1342L provided in parallel are formed on different chips from each other. As such, in case a plurality of transistors that should operate in the same way are formed on different chips, variation in the manufacturing process of each of the chips and the like may cause a difference in the current flowing through each of the transistors. If the situation in which excessive current is concentrated onto one transistor due to this imbalance of the current persists, the likelihood of failure of the transistor or the entire device increases. Therefore, in case semiconductor elements such as transistors are formed on different chips for higher electric power, it is important to maintain the proper balance of the currents between the semiconductor elements.

Figure 3 schematically shows a configuration that maintains the balance of the currents between the transistors 1341 and 1342 formed on different chips. To begin with, the structures of the transistors 1341 and 1342 will be described. The transistors 1341 and 1342 are field effect transistors or MOSFETs (metal oxide semiconductor field effect transistors) with vertical structures, and have the same structures as each other except that they are formed on different silicon wafers (chips).

On the surface of the silicon wafer of each of the transistors (the upper face in Figure 3), a gate electrode 31 configuring the gate of the transistor is provided via a gate insulating film 32. A source region 33 configuring the source of the transistor, is an n-type region formed on the silicon wafer so as to sandwich from both sides or annularly surround the gate electrode 31 in the top view. Besides, a p-type channel region 34 is formed on the silicon wafer so as to surround the source region 33. Most of the silicon wafer except for the n-type source region 33 and the p-type channel region 34 configures the n-type substrate body 35. On the back side of the silicon wafer (the lower face in Figure 3), a drain electrode 36 configuring the drain of the transistor is provided.

In the transistor with the above configuration, when positive voltage is applied to the gate electrode 31, an n-type inversion layer (channel) is formed in the p-type channel region 34 immediately below the gate insulating film 32, so that the n-type source region 33 becomes conductive with the n-type substrate body 35 and the drain electrode 36. Between the source and the drain becoming conductive in this way, the current can flow in a roughly vertical direction in Figure 3, i.e., a direction connecting the surface and the back side of the silicon wafer. In Figure 3, the current flowing from the drain (bottom) to the source (top) is shown by the upward arrow, but current can also flow from the source (top) to the drain (bottom).

The current flowing between the source and the drain of the transistor 1341 is indicated as I₁, and the current flowing between the source and the drain of the transistor 1342 is indicated as I₂. In case these transistors 1341 and 1342 are used as the high electric potential transistors 1341H and 1342H in Figure 2 or the low electric potential transistors 1341L and 1342L in Figure 2, since the common driver (135H or 135L) inputs the same control signals to the gate electrodes 31 of each of the transistors 1341 and 1342, the currents flowing through them should always be equal (I₁ = I₂). However, due to variation in the manufacturing process of each of the chips on which each of the transistors 1341 and 1342 is formed and the like, there is the likelihood that the currents flowing through them may differ (I₁ > I₂ or I₁ < I₂).

In order to eliminate such an imbalance of the current, a magnetic member 40 is provided according to the present embodiment. As schematically shown in Figure 3, the magnetic member 40 configures an endless or unterminated circulating magnetic path in the shape of "8" or "∞" in the top view. Specifically, a first annular magnetic path 41 magnetically coupled with the first chip on which the transistor 1341 is formed, and a second annular magnetic path 42 magnetically coupled with the second chip on which the transistor 1342 is formed, are connected in an unterminated manner to form the circulating magnetic path. Here, the circulating direction of the first annular magnetic path 41 around the current I₁ in the first chip and the circulating direction of the second annular magnetic path 42 around the current I₂ in the second chip are opposite to each other. As illustrated by the arrows in Figure 3, in case the circulating direction of the first annular magnetic path 41 around the upward current I₂ is the clockwise direction, the circulating direction of the second annular magnetic path 42 around the similarly upward current I₂ is the counterclockwise direction.

According to the magnetic member 40 with the above configuration, the magnetic flux generated by the current in one chip is directed or led to another chip, and the current in the same direction as that in the one chip is induced in another chip. For example, the magnetic flux B₂ generated in the second annular magnetic path 42 by the upward current I₂ in the transistor 1342 is directed or led to the first annular magnetic path 41 by the magnetic member 40. Here, the magnetic flux B₂ generated in the second annular magnetic path 42 is in a counterclockwise direction, while the magnetic flux B₁ directed or led to the first annular magnetic path 41 is in a clockwise direction. In the transistor 1341, the current I₁ is induced to cancel out the magnetic flux B₁ generated by the current I₂ in the transistor 1342. Specifically, the upward current I₁ is induced to generate the magnetic flux B1' in a counterclockwise direction that cancels out the magnetic flux B₁ in a clockwise direction. As such, the magnetic member 40 causes the upward current I₂ in the transistor 1342 to induce the upward current I₁ in the transistor 1341. Similarly, the upward current I₁ in the transistor 1341 induces the upward current I₂ in the transistor 1342. Furthermore, the above descriptions are also applicable to the case where the currents I₁ and I₂ are downward.

In the ideal case where the currents flowing through each of the transistors 1341 and 1342 are equal (I₁ = I₂), no current is induced in either transistor since the above mechanisms are balanced between both of the transistors. On the other hand, in case there is a difference in the currents flowing through each of the transistors 1341 and 1342, the transistor with the larger current induces the current in the transistor with the smaller current, and the difference in the currents is naturally eliminated. As such, according to the magnetic member 40, the balance of the currents between the transistors 1341 and 1342 can be properly maintained.

As long as the above mechanism works, the position and/or manner that the magnetic member 40 is installed is not limited, and three installation positions 40A to 40C are illustrated in Figure 3. At the installation position 40A, the magnetic member 40 is placed above the surface of the silicon wafer, and each of the source currents I₁ and I₂ flowing through the source region 33 makes interlinkage with the first annular magnetic path 41 and the second annular magnetic path 42 respectively. At the installation position 40B, each of the annular magnetic paths 41 and 42 of the magnetic member 40 is arranged to surround the sides or the circumference of the respective silicon wafers of the transistors 1341 and 1342, and each of the substrate currents I₁ and I₂ flowing through the substrate body 35 makes interlinkage with the first annular magnetic path 41 and the second annular magnetic path 42 respectively. Here, the magnetic member 40 "surrounds" the silicon wafer, not only in the case where the magnetic member 40 and the silicon wafer are in contact without any gap, but also in the case where a space, an insulating material, or the like is interposed between the magnetic member 40 and the silicon wafer. At the installation position 40C, the magnetic member 40 is placed below the back side of the silicon wafer, and each of the drain currents I₁ and I₂ flowing through the drain electrode 36 makes interlinkage with the first annular magnetic path 41 and the second annular magnetic path 42 respectively.

Figure 4 shows an example in which the technological concept of Figure 3 is applied to an insulated gate bipolar transistor (IGBT). While the same reference signs are given to the equivalent components to the MOSFET in Figure 3, 33 is the emitter region and 36 is the collector electrode in the IGBT. Besides, a p-type layer 37 is provided between the substrate body 35 and the collector electrode 36 to form a pnp-type bipolar transistor with the p-type channel region 34 and the n-type substrate body 35.

When positive voltage is applied to the gate electrode 31, a channel is formed in the channel region 34 immediately below the gate insulating film 32 as in the MOSFET in Figure 3, and electrons as the n-type carriers flow from the emitter region 33 to the substrate body 35. This flow of electrons becomes the base current to the pnp-type bipolar transistor described above, so that the bipolar transistor also becomes conductive to make the emitter and the collector conductive. Between the emitter and the collector becoming conductive in this way, the current can flow in a roughly a direction connecting the surface and the back side of the chip as in the MOSFET in Figure 3. In Figure 4, the current flowing from the collector (bottom) to the emitter (top) is shown by the upward arrow, but current can also flow from the emitter (top) to the collector (bottom). The configuration and/or the function of the magnetic member 40 to maintain the balance of the currents I₁ and I₂ in both IGBTs 1341 and 1342 are similar to those in Figure 3, therefore the duplicated explanation is omitted.

Figure 5 shows an example in which the technological concept of Figure 3 is applied to a field effect transistor or a MOSFET with a horizontal structure. In the MOSFET with the horizontal structure, an n-type source region 33 and an n-type drain region 36 are formed on the silicon wafer to sandwich the gate electrode 31 from both sides in the top view. When positive voltage is applied to the gate electrode 31, an n-type inversion layer (channel) is formed in the p-type channel region 34 immediately below the gate insulating film 32, so that the n-type source region 33 and the n-type drain region 36 become conductive. Between the source and the drain becoming conductive in this way, the current can flow in a roughly horizontal direction in Figure 5, i.e., a direction connecting the source region 33 and the drain region 36 near the surface of the silicon wafer. In Figure 5, the current flowing from the drain (right) to the source (left) is shown by the leftward arrow, but current can also flow from the source (left) to the drain (right).

The magnetic member 40 to maintain the balance of the currents I₁ and I₂ of both of the transistors 1341 and 1342, is provided to magnetically couple both of the source currents and/or both of the drain currents of both of the transistors. The magnetic member 40S magnetically couples the sources of both of the transistors 1341 and 1342. In the example shown in the figure, the source current I₁ of the transistor 1341 and the source current I₂ of the transistor 1342, both of which are upward, make interlinkage with the first annular magnetic path 41 and the second annular magnetic path 42 respectively. Here, it is assumed that the layout is adjusted as necessary so that the drain currents in both of the transistors 1341 and 1342 do not make interlinkage with the magnetic member 40S. The magnetic member 40D magnetically couples the drains of both of the transistors 1341 and 1342. In the example shown in the figure, the drain current I₁ of the transistor 1341 and the drain current I₂ of the transistor 1342, both of which are downward, make interlinkage with the first annular magnetic path 41 and the second annular magnetic path 42 respectively. Here, it is assumed that the layout is adjusted as necessary so that the source currents in both of the transistors 1341 and 1342 do not make interlinkage with the magnetic member 40D. The magnetic member 40 as described above, can properly maintain the balance of the source currents and/or the drain currents between the transistors 1341 and 1342.

Figure 6 shows an example of the implementation of the transistors 1341 and 1342. Inside the package 50 housing or accommodating the transistors 1341 and 1342, a pair of mounting substrates 51U and 51D on which the first chip on which the transistor 1341 is formed and the second chip on which the transistor 1342 is formed are mounted. On the upper mounting substrate 51U, the surfaces on which the gates and sources of the transistors 1341 and 1342 in Figure 3 are provided are mounted. On the lower mounting substrate 51D, the back sides on which the drains of the transistors 1341 and 1342 in Figure 3 are provided are mounted. Each of the mounting substrates 51U and 51D has a wiring layer 52 that is electrically connected to terminals of the chip such as the gate, the source and the drain, to input and/or output signals. Each of the wires in the wiring layer 52 and each of the terminals of each of the chips, are electrically connected by a via 53 that extends in a direction perpendicular to the wiring layer 52 or in the thickness direction of the package 50.

The magnetic member 40 to maintain the balance of the currents I₁ and I₂ of both of the chips, is provided in at least one of the installation positions 40A to 40C as shown in Figure 3. At the installation position 40A, the magnetic member 40 is arranged to surround the circumference of the respective vias 53 above the surfaces of both of the chips, and the currents I₁ and I₂ flowing through these vias 53 in the vertical direction (upward in the example of Figure 6) makeinterlinkages with the first annular magnetic path 41 and the second annular magnetic path 42 respectively. At the installation position 40B, each of the annular magnetic paths 41 and 42 of the magnetic member 40 is arranged to surround the sides or the circumference of each of the first chip and the second chip, and the currents I₁ and I₂ flowing in the thickness direction of the chips make interlinkages with the first annular magnetic path 41 and the second annular magnetic path 42 respectively. At the installation position 40C, the magnetic member 40 is arranged to surround the circumference of the respective vias 53 below the back sides of both of the chips, and the currents I₁ and I₂ flowing through these vias 53 in the vertical direction (upward in the example of Figure 6) makeinterlinkages with the first annular magnetic path 41 and the second annular magnetic path 42 respectively. In any of the installation positions 40A to 40C, the magnetic member 40 magnetically couples the first chip and the second chip inside the package 50, directing the magnetic flux generated by the current in one chip to another chip and configuring the magnetic path that induces the current in another chip in the same direction as that in one chip.

In the above installation positions 40A to 40C, the magnetic member 40 has been arranged so that the currents I₁ and I₂ flowing through each of the chips in the vertical direction. However, since these currents I₁ and I₂ flow through the wires in the wiring layer 52 in the horizontal plane in Figure 6, the magnetic member 40 may be configured to make interlinkages with these wires. To express this in an abstracted manner, the magnetic member 40 may be configured to surround the circumference of each of the conductive members that are electrically connected to the current terminals of each of the chips. In the present embodiment, the wiring layer 52 and the via 53 configure the conductive members.

Figure 7 shows another example of the implementation of the transistors 1341 and 1342. Whereas the package 50 in Figure 6 has the configuration in which the first chip and the second chip are sandwiched between the pair of upper mounting substrate 51U and the lower mounting substrate 51D, in the package 50 in Figure 7, the first chip and the second chip are mounted inside a single mounting substrate 51. In the example shown in the figure, each of the terminals of each of the chips are electrically connected via each of the wires in the wiring layer 52 and the via 53 below. The magnetic member 40 to maintain the balance of the currents of both of the chips, is placed at the installation position 40C surrounding each of the vias 53 of both of the chips, and the currents I₁ and I₂ flowing through these vias 53 in the vertical direction (upward in the example shown in the figure) make interlinkage with the first annular magnetic path 41 and the second annular magnetic path 42 respectively.

The magnetic member 40 according to the present embodiment is suitable for a semiconductor device that does not use a bonding wire for electrical connection with the chip inside the package 50, as shown in Figure 6 and/or Figure 7. In a semiconductor device that uses a bonding wire, the variation of the currents between the chips is naturally suppressed to some extent, by the inductance and/or the resistance of the bonding wire itself that connects the terminal of the chip and the lead of the package and/or the lead. In contrast, in case a technology such as the flip chip bonding without the bonding wires is used, there is no need to provide a space inside the package 50 for the bonding wires, therefore allowing for high density mounting. On the other hand, the magnetic member 40 according to the present embodiment is provided to compensate for the loss of the effect of the bonding wires and/or the leads in suppressing the variation of the currents between the chips. In other words, since the magnetic member 40 according to the present embodiment can suppress the effect of the variation in the manufacturing process of each of the chips and the like, it is no longer necessary to strictly select the chips considering the exact variation. It should be noted that, although it is also possible to reduce the imbalance of the currents between the chips by providing a balance reactor on the current path of each of the chips, it is not desirable to place such a large inductance component on the signal path that would inhibit high speed operation, especially in an application that requires high speed switching at the nanosecond level. The magnetic component 40 according to the present embodiment is not electrically connected to each of the chips, therefore it can be compatible with high speed operation of a semiconductor device.

The method of manufacturing the magnetic member 40 is not particularly limited, but the magnetic member 40 can be modeled from the desired magnetic material using a 3D printer, for example. Besides, when the chip is mounted inside the package 50, the magnetic particles stacked at the desired positions around the chip can be sequentially hardened by a laser or the like to form the magnetic member 40 of the desired shape. Besides, the magnetic material forming the magnetic member 40 is also not particularly limited, but it is preferable to use a magnetic material with a small voltage time product, a small saturation magnetic flux density, and hysteresis close to square (with a squareness ratio close to 1), for example, so as not to substantially interfere with high speed operation of a semiconductor device.

The present invention has been described above based on embodiments. It will be understood by those skilled in the art that the embodiments are examples, that various variations are possible in the combination of the respective components and/or the respective processing steps, and that such variations are also within the scope of the present invention.

In the embodiment, the transistor has been illustrated as the semiconductor element, but the present invention can also be applied to other semiconductor elements such as a thyristor and a diode. In other words, the magnetic member 40 magnetically coupled with a plurality of semiconductor elements can properly maintain the balance of the currents between the semiconductor elements.

Although the embodiment has described an example in which the semiconductor element is formed on Si, the semiconductor elements may also be formed on wide band gap semiconductor material such as SiC and GaN, which has a larger band gap than Si.

In the embodiment, the example has been described in which the magnetic member 40 takes the balance of the currents in the transistors 1341 and 1342, which operate in substantially the same manner, but the magnetic member 40 may be used for an application for balancing the currents and/or suppressing the variation of the currents between the semiconductor elements that operate differently.

In the embodiment, the magnetic member 40 has been shaped like "8" or "∞" in the top view, but the shape of the magnetic member 40 is arbitrary as long as it performs the function of "magnetically coupling the first chip and the second chip inside the package 50, directing the magnetic flux generated by the current in one chip to another chip, and configuring the magnetic path that induces the current in another chip in the same direction as that in the one chip".

In the embodiment, the first chip (the transistor 1341) and the second chip (the transistor 1342) have configured the inverter 13 (the power conversion unit) that converts the DC power into the AC power, but a converter as the power conversion unit that converts the AC power into the DC power may also be configured. Besides, the power conversion unit that converts the magnitude and/or the frequency (only between the AC power) between the DC power or between the AC power, may be configured by the first chip and the second chip. In case the magnetic member 40 is applied to such a power conversion unit, it is possible to generate the magnetic flux that reduces the difference in the power between the first chip and the second chip.

In the embodiment, the inverter 13 that converts the DC power to the AC power has been illustrated as the power conversion apparatus, but the present invention can also be applied to other power conversion apparatus such as a converter that converts AC power into DC power and a DC/DC converter that converts power between DC powers.

It should be noted that the functional configuration of each device described in the embodiment can be realized by hardware resources or software resources, or by collaboration of hardware resources and software resources. As hardware resources, processor, ROM, RAM, and other LSI can be utilized. As software resources, operating system, application, and other program can be utilized.

In the embodiments disclosed in the present specification, some or all of a plurality of functions provided in a distributed manner may be provided by incorporating into an integral function, and conversely an integral function incorporating a plurality of functions may be provided by distributing some or all of the plurality of functions. Regardless of whether the functions are incorporated or distributed, it is sufficient if they are configured so that the purpose of the present invention can be achieved.

The present invention relates to semiconductor device.

### REFERENCE SIGNS LIST

10 inverter apparatus, 13 inverter, 20 motor, 40 magnetic member, 41 first annular magnetic path, 42 second annular magnetic path, 50 package, 51 mounting substrate, 52 wiring layer, 53 via, 131 high electric potential input terminal, 132 low electric potential input terminal, 133 output terminal, 134 transistor pair, 135 driver pair, 1341 transistor, 1342 transistor.

## Claims

1. A semiconductor device comprising:
a first chip on which a semiconductor element is formed;
a second chip different from the first chip on which a semiconductor element is formed;
a package comprising a mounting substrate on which the first chip and the second chip are mounted; and
a magnetic member magnetically coupling the first chip and the second chip inside the package, and configuring a magnetic path that directs the magnetic flux generated by the current in one chip to another chip and induces the current in another chip in the same direction as that in the one chip.

2. The semiconductor device according to claim 1, wherein
the magnetic member configures the circulating magnetic path in which a first annular magnetic path magnetically coupled to the first chip and a second annular magnetic path magnetically coupled to the second chip are connected in an unterminated manner, and
the circulating direction of the first annular magnetic path around the current in the first chip and the circulating direction of the second annular magnetic path around the current in the second chip are opposite to each other.

3. The semiconductor device according to claim 1 or 2, wherein
field effect transistors as the semiconductor elements are formed on the first chip and the second chip, and
the magnetic member magnetically couples the sources or drains of the field effect transistors of the first chip and the second chip.

4. The semiconductor device according to any of claims 1 to 3, wherein the magnetic member surrounds each of the first chip and the second chip.

5. The semiconductor device according to any of claims 1 to 3,
further comprising a first conductive member electrically connected to a current terminal of the first chip and a second conductive member electrically connected to a current terminal of the second chip, wherein
the magnetic member surrounds each of the first conductive member and the second conductive member.

6. The semiconductor device according to claim 5, wherein
the mounting substrate has a wiring layer,
the first conductive member is configured by a wire in the wiring layer and a first via that connects the wire and the current terminal of the first chip,
the second conductive member is configured by a wire in the wiring layer and the second via that connects the wire and the current terminal of the second chip, and
the magnetic member surrounds each of the first via and the second via.

7. The semiconductor device according to any of claims 1 to 6, wherein the first chip and the second chip are configured by the wide band gap semiconductor.

8. The semiconductor device according to any of claims 1 to 7, wherein
the first chip and the second chip configure a power conversion unit that converts input power into output power, and
the magnetic member generates the magnetic flux that reduces the difference in power of the first chip and the second chip.

9. A power conversion apparatus comprising:
a DC power terminal including a high electric potential terminal at high electric potential and a low electric potential terminal at low electric potential, between which DC power is input or output;
an AC power terminal in which AC power is input or output;
a high electric potential transistor that connects the high electric potential terminal side and the AC power terminal side;
a low electric potential transistor that connects the low electric potential terminal side and the AC power terminal side; and
a driver that inputs control signals to the high electric potential transistor and the low electric potential transistor, and performs conversion between the DC power and the AC power by complementarily switching their respective conduction states, wherein
at least one of the high electric potential transistor and the low electric potential transistor includes a first transistor and a second transistor to which the same control signals are input by the driver,
the first transistor is formed on a first chip,
the second transistor is formed on a second chip different from the first chip,
a package comprising a mounting substrate on which the first chip and the second chip are mounted is provided, and
a magnetic member magnetically coupling the first chip and the second chip inside the package, and configuring a magnetic path that directs the magnetic flux generated by the current in one chip to another chip and induces the current in another chip in the same direction as that in the one chip is provided.
